# EUROPEAN PATENT APPLICATION

(11) **EP 4 841 234 A1**
(43) Date of publication of application: **18.11.2026**
(21) Application number: 25175803.3
(22) Date of filing: 12.05.2025
(51) Int. Cl.: G01N 1/28, G01N 1/32, H01J 37/20, H01J 37/30, G01N 1/04

(54) **SYSTEM, METHOD, AND COMPUTER PROGRAM FOR AN ION MILLING DEVICE, CALIBRATION SAMPLE, AND ION MILLING DEVICE**

(71) Applicant: Leica Mikrosysteme GmbH, 1170 Wien (AT)
(72) Inventor: WELLER, Miriam, 1170 Wien (AT)
(74) Representative: 2SPL Patentanwälte PartG mbB

(57) **Abstract**

Examples relate to a system (110), a method, and a computer program for an ion milling device (100), to an ion milling device (100) comprising such a system (110), and to a calibration sample (10) for such an ion milling device (10). The system (110) is configured to obtain image data of an optical imaging device (120) of the ion milling device, the image data showing a calibration sample mounted on a sample stage (140) while the calibration sample (10) is irradiated by at least one ion beam (20) emitted by at least one ion emitter (130), and process the image data to determine at least one of a position or orientation of the at least one ion beam (20) relative to the sample stage.

## Description

### Technical field

Examples relate to a system, a method, and a computer program for an ion milling device, to an ion milling device comprising such a system, and to a calibration sample for such an ion milling device.

### Background

Ion milling is a process used to remove material from a surface using a beam of ions. The ions collide with the surface, gradually removing material through physical sputtering. It is commonly used as a preparatory operation before electron microscopy, in semiconductor manufacturing, and in materials science for precise surface preparation.

The diameter of the ion beam used in ion milling is small, and the beam's intensity distribution peaks in the middle. To achieve the best cross-sectioning performance, the center of the ion beam should hit the mask edge, which ensures maximum utilization of the ions for cross-sectioning of the sample. In many current ion milling devices, there is no mechanism for measuring the position of the ion beam inside the vacuum chamber and positioning the mask and sample accordingly.

There may be a desire to provide an improved concept for arranging a sample in an ion milling device.

### Summary

This desire is addressed by the subject matter of the independent claims.

Various examples of the present disclosure are based on the finding that, while it is difficult to observe the ion beam during the ion milling process due to the removed material being deposited on the objects inside the chamber, including a camera, ion beams can be safely observed before the actual milling process, e.g., if the ion beam is only activated for a short period of time, with a reduced power, and/or targeted at a material that is less prone to sputtering, such as a calibration sample. This can be used to determine the position and/or angle at which the ion beam(s) intersect with the mask and sample at the current relative position of the respective ion emitter and sample stage. If the ion beam hits the calibration sample at the right position (and angle), the relative position and/or orientation can be maintained, or adjusted otherwise. This way, the cross-sectioning performance can be improved in cases in which there initially was a misalignment between the ion beam, mask, and sample.

Some aspects of the present disclosure relate to a system for an ion milling device. The system comprises one or more processors and one or more storage devices. The system is configured to obtain image data of (e.g., from) an optical imaging device of the ion milling device. The image data shows a calibration sample mounted on a sample stage while the calibration sample is irradiated by at least one ion beam emitted by at least one ion emitter. The system is configured to process the image data to determine at least one of a position or orientation of the at least one ion beam relative to the sample stage. This way, a misalignment between the ion beam and the mask and sample can be determined and used to take action to improve the alignment, thus improving the cross-sectioning performance.

In general, the outer shape of the calibration sample may be used as a reference to calculate the position at which the ion beam hits the calibration sample relative to a coordinate system of the ion milling device. To facilitate and improve the precision of the calculation of the position, positional reference marker(s) may be arranged on the calibration sample or sample stage. For example, the image data may show at least one positional reference marker of the sample stage or calibration sample. The system may be configured to determine the position and/or orientation of the at least one ion beam relative to the sample stage based on the at least one positional reference marker of the sample stage or calibration sample.

In general, a camera may be unsuitable for directly observing the ion beam (which may be an Argon ion beam), as the ion beam's emissions in the visible spectrum can be very weak and, thus, hard to observe. However, if the ion beam interacts with a medium (e.g., gas, air, or a surface) and causes ionization or excitation, resulting in light emission (e.g., plasma or fluorescence), the emitted light from this interaction can be captured by the optical imaging device. Thus, the system may be configured to determine the position and/or orientation of the at least one ion beam based on an intensity distribution of a visually perceivable reaction of the calibration sample to the at least one ion beam. This way, the position at which the ion beam interacts with the calibration sample can be determined, although the ion beam may, per se, not be visible or observable to the optical imaging sensor.

In an ion milling device, the midpoint of the ion beam is of particular interest, as it is desirable to place the midpoint at the edge of the mask in cross-sectioning processes. For example, the system may be configured to determine the midpoint of the intensity distribution and use the position of the midpoint to determine the position and/or orientation of the at least one ion beam. This way, the position of the midpoint of the ion beam, which is of particular interest in ion milling, is determined, and can subsequently be placed such that the midpoint of the ion beam hits the edge of the mask.

In some examples, machine learning may be used to determine the position of the midpoint in the image data. For example, the system may be configured to process the image data using a machine learning model trained to output the position of the midpoint of the intensity distribution in the image data. A machine learning model is able to accurately and adaptively identify the midpoint of complex, non-linear, or noisy intensity distributions by learning patterns from data, reducing reliance on manual calibration and improving robustness in varying conditions.

The proposed concept is not limited to a single ion beam. In particular, it may be applied in ion mills using multiple ion emitters, to align the resulting ion beams onto a common intersection point with the sample. For example, the system may be configured to, if the ion milling device comprises two or more ion emitters, process two or more frames of image data, with each frame of image data showing the irradiation of the calibration sample by a single one of the ion emitters. The system may be configured to process the frames of image data separately to determine the position and/or orientation of the two or more ion beams emitted by the two or more ion emitters relative to the sample stage. This way, the two or more ion beams may be targeted at the same point on the sample.

Alternatively, the position and/or orientation of multiple ion beams may be determined using a single frame or frames of image data being based on multiple ion beams. For example, system may be configured to, if the ion milling device comprises two or more ion emitters, process at least one frame of image data, with each of the at least one frame showing the irradiation of the calibration sample by the two or more ion emitters. The system may be configured to process the at least one frame of image data to determine the position and/or orientation of the two or more ion beams emitted by the two or more ion emitters relative to the sample stage. While this approach is computationally more difficult, it requires fewer image frames to be captured.

The proposed mechanism is not only useful for determining the position (and angle) of the ion beam relative to the calibration sample, and thus the sample stage, but also for taking actions to place the calibration sample at an improved position and/or orientation relative to the ion emitter. This can be done by changing the position and/or orientation of the ion emitter(s), and/or by changing the position and/or orientation of the sample stage. For example, the system may be configured to control an ion emitter positioning mechanism to adjust at least one of a position or orientation of the at least one ion emitter based on the position or orientation of the at least one ion beam emitted by the at least one ion emitter relative to the sample stage. This way, the relative position and orientation of the at least one ion emitter can be changed so that the midpoint of the respective ion beam hits the edge of the mask (and/or so that multiple ion beams hit the same point of the mask and sample).

Adjusting the relative position and orientation of the ion emitter(s) and sample stage by changing the position and/or orientation of the ion emitter(s) provides an additional degree of flexibility, as the relative position and/or orientation of multiple ion emitters relative to the sample stage can be changed independently of each other. Thus, the system may be configured to, if the ion milling device comprises two or more ion emitters, control at least one ion emitter positioning mechanism to adjust the position and/or orientation of the two or more ion emitters based on the position or orientation of respective ion beams emitted by the respective ion emitters. This way, the position and/or orientation of the ion emitters can be changed independently of each other.

In some cases, the position and/or orientation of the ion emitter(s) can be changed automatically, e.g., using servo motors of the at least one ion emitter positioning mechanism. However, the proposed concept is also applicable in cases in which the position and/or orientation of the ion emitters has to be changed manually, e.g., using highly precise calibration screws. In this case, the user of the ion milling device may be guided to perform the adjustments. For example, the system may be configured to provide a display signal for a display device of the ion milling device. The display signal may comprise information on how to adjust the position and/or orientation of the at least one ion emitter. For example, the information on how to adjust the position and/or orientation of the at least one ion emitter may be based on the position and/or orientation of the at least one ion beam. This way, the user can, in a guided manner, adjust the position and/or orientation of the ion emitters to target the sample.

As an alternative to, or in addition to, changing the position and/or orientation of the ion emitters, the position and/or orientation of the sample stage may be changed. For example, the system may be configured to control a sample stage positioning mechanism to adjust at least one of a position or orientation of the sample stage based on the position or orientation of the at least one ion beam emitted by the at least one ion emitter relative to the sample stage. This way, the relative position and orientation of the at least one ion emitter can be changed so that the midpoint of the ion beam(s) hit(s) the edge of the mask.

Again, if the ion milling device does not include an automatic sample stage positioning mechanism, the user may be guided to perform the requisite adjustments. For example, the system may be configured to provide a display signal for a display device of the ion milling device. For example, the display signal may comprise information on how to adjust the position and/or orientation of the sample stage. The information on how to adjust the position and/or orientation of the sample stage may be based on the position and/or orientation of the at least one ion beam. This way, the user can, in a guided manner, adjust the position and/or orientation of the sample stage so that the ion beam(s) target the sample.

In some cases, it is beneficial to not only know the position of the point at which the ion beam intersects with the calibration sample, but also the angle of the ion beam relative to the calibration sample, e.g., to extrapolate the point at which the respective ion beam intersects with the 'real' sample and/or mask. For this purpose, multiple image frames may be captured, with the relative position between the ion emitter(s) and the sample stage changing between the image frames. This allows for the extrapolation of the angle of the ion beam. For example, the system may be configured to control a sample stage positioning mechanism (or ion beam positioning mechanism) to adjust a distance between the sample stage and the at least one ion emitter. The system may be configured to obtain at least a first frame of image data showing the calibration sample at a first distance from the at least one ion emitter and a second frame of image data showing the calibration sample at a second distance from the at least one ion emitter. The system may be configured to determine the orientation of the at least one ion beam based on the first and second frames of image data. This way, an accurate targeting of the sample and mask is enabled in cases in which the ion beam is not orthogonal to an ion emitter-facing side of the sample, e.g., in case multiple ion emitters are used that irradiate the sample from different angles.

In an alternative implementation, for example if the relative position of the sample stage and the ion emitter(s) cannot be changed automatically, the distance between the sample stage and the ion emitter(s) can also be changed manually between capturing the frames of image data. For example, the system may be configured to obtain at least a first frame of image data showing the calibration sample at a first distance from the at least one ion emitter prior to a manual adjustment of the sample stage and a second frame of image data showing the calibration sample at a second distance from the at least one ion emitter after the manual adjustment of the sample stage. The system may be configured to determine the orientation of the at least one ion beam based on the first frame and second frame of image data. This way, the angle can be determined without requiring an automatic positioning mechanism for the sample stage and/or ion emitter(s).

To determine the orientation of the at least one ion beam, a straight line may be projected through the midpoints of the intensity distributions shown in the various image frames. For example, the system may be configured to determine the orientation of the at least one ion beam by determining a straight line between the midpoints of respective intensity distributions of a visually perceivable reaction of the calibration sample to the at least one ion beam shown in the first and second frames.

Some aspects of the present disclosure relate to a first calibration sample for an ion milling device. The calibration sample comprises a glass plate to be irradiated by an ion beam emitted by an ion emitter of the ion milling device. The calibration sample comprises a mirror configured to reflect light of a visually perceivable reaction of the glass plate to the irradiation by the ion beam towards an optical imaging device of the ion milling device. This way, a microscope, which is often used to align the sample and mask on the sample stage, can also be used to capture the image data of the calibration sample. Providing a separate camera for capturing the image data is not necessary.

Some aspects of the present disclosure relate to a second calibration sample for an ion milling device. The second calibration sample comprises a surface configured to emit light of a visually perceivable reaction of the surface to the irradiation by an ion beam towards an optical imaging device of the ion milling device. The surface is arranged such that, when the calibration sample is mounted to the sample stage, the surface is at an angle of between 40 degrees and 50 degrees relative to an ion emitter-facing surface of the sample stage. This way, a microscope, which is often used to align the sample and mask on the sample stage, can also be used to capture the image data of the calibration sample. Providing a separate camera for capturing the image data is not necessary.

Another aspect of the present disclosure relates to an ion milling device comprising the system, a sample stage, an optical imaging device, and at least one ion emitter. For example, the ion milling device may further comprise the first calibration sample, the second calibration sample, or a planar calibration sample.

For example, the sample stage may be provided for use with the calibration sample and for use with samples to be milled using the ion milling device. This way, a separate sample stage is not necessary. Moreover, misalignment due to minor differences between the position of a sample stage used for calibration and a sample stage used for ion milling can be avoided.

If a planar (e.g., metal or glass) calibration sample is used, ideally, the image data is at an approximate 45-degree angle. For example, an angle between an ion emitter-facing surface of the sample stage and a straight line between the optical imaging device and a center point of the emitter-facing surface of the sample stage may be at least 40 degrees and at most 50 degrees. This way, distortions caused by the angular offset can be reduced.

If a planar glass calibration sample is used, the optical imaging device (e.g., camera) may also be placed on the opposite side of the planar glass calibration sample than the ion emitter(s). This way, the optical imaging device can observe the visually perceivable reaction of the glass plate to the irradiation by the ion beam from "behind" the planar glass calibration sample.

As an alternative to a planar calibration sample, a calibration sample may be used that includes a mirror to reflect the light towards the optical imaging device, e.g., the first calibration sample. For example, the optical imaging device may be positioned to generate image data of the light reflected by a mirror of a calibration sample mounted on the sample stage. This way, a microscope, which is often used to align the sample and mask on the sample stage, can also be used to capture the image data of the calibration sample. Providing a separate camera for capturing the image data is not necessary.

As a further alternative to a planar calibration sample, a calibration sample may be used that includes a surface that is slanted relative to the ion emitter-facing side of the sample stage, e.g., the second calibration sample. For example, the optical imaging device may be positioned to generate image data of light emitted by a surface of a calibration sample mounted on the sample stage, with the surface being at an angle of between 40 degrees and 50 degrees relative to an ion emitter-facing surface of the sample stage. This way, a microscope, which is often used to align the sample and mask on the sample stage, can also be used to capture the image data of the calibration sample. Providing a separate camera for capturing the image data is not necessary.

Some aspects of the present disclosure relate to a corresponding method for an ion milling device. The method comprises obtaining image data of (e.g., from) an optical imaging device of the ion milling device. The image data shows a calibration sample mounted on a sample stage while the calibration sample is irradiated by at least one ion emitter. The method comprises processing the image data to determine at least one of a position or orientation of at least one ion beam emitted by the at least one ion emitter relative to the sample stage.

An aspect of the present disclosure relates to a computer program having a program code for performing the above method when the program is executed on a processor.

### Short description of the Figures

Some examples of apparatuses and/or methods will be described in the following by way of example only, and with reference to the accompanying figures, in which
- Figs. 1a and 1b: show schematic diagrams of an example of a system for an ion milling device and of an ion milling device;
- Fig. 2: shows a schematic diagram of a system for an ion milling device and of an ion milling device, with a camera that is placed inside the chamber and used as the optical imaging device;
- Figs. 3a and 3b: show schematic diagrams of a system for an ion milling device and of an ion milling device, with a digital or hybrid microscope that is used as the optical imaging device;
- Fig. 4: shows a schematic diagram of a calibration sample mounted on a sample stage, showing an intensity distribution of a visually perceivable reaction of the calibration sample to an ion beam;
- Fig. 5: shows a schematic diagram of a calibration sample being irradiated by three ion emitters;
- Fig. 6: shows a flowchart of an example of a method for an ion milling device; and
- Fig. 7: shows a schematic diagram of a system comprising an optical imaging device and a computer system.

### Detailed Description

Various examples will now be described more fully with reference to the accompanying drawings in which some examples are illustrated. In the figures, the thicknesses of lines, layers and/or regions may be exaggerated for clarity.

The present disclosure relates to ion milling. Ion milling is a technique used to etch or clean the surface of materials using a beam of ions that is emitted by an ion source, such as an argon ion source. Ion milling works by directing a high-energy beam of ions at the surface of a sample. As these ions collide with the atoms at the surface of the material, they effectively sputter away the atoms, gradually eroding the surface. This process is known for its precision and is commonly used in scenarios where traditional mechanical or chemical methods might be too harsh or imprecise.

The technique is widely utilized in the preparation of samples for electron microscopy, where a clean, smooth surface is crucial for accurate imaging. It is also employed in the microelectronics industry for thinning semiconductor samples, enabling detailed analysis. Additionally, ion milling is used in materials science research, where understanding the composition and structure of materials at the microscopic level is beneficial.

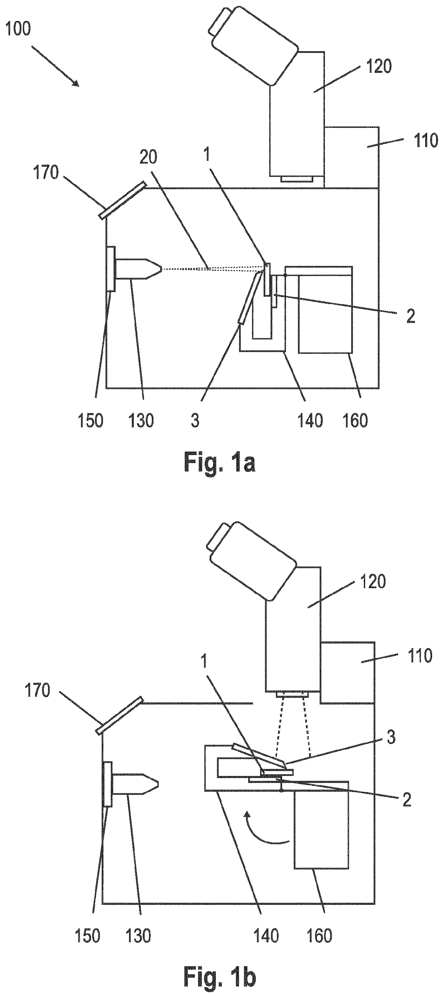

Fig. 1a shows a schematic diagram of an example of an ion milling device 100 during ion milling of a sample 1. An ion milling device 100 typically comprises several components. These include at least one ion emitter 130, which comprises the ion source that generates the ion beam (commonly using Argon gas) and ion optics, which are used to direct the beam 20 onto the sample 1. An ion emitter positioning mechanism 150 (e.g., an ion beam targeting mechanism) is used to target the sample by adjusting at least one of a lateral position, vertical position, or orientation of the at least one ion emitter 130.

A sample stage 140 holds and precisely positions the sample during processing. The sample 1 is attached to a sample holder 2, which is mounted to the sample stage 140. A mask 3 partially shields the sample 1 during ion milling. A mechanical sample stage positioning mechanism 160, e.g., a motorized sample stage, is used to position the sample stage 140 with the sample 1 relative to the ion beam 20, with the sample stage positioning mechanism 160 being configured to adjust at least one of a lateral position, vertical position, or orientation of the sample stage 140, and therefore of the sample 1. The ion milling device 100 may also use vacuum equipment to maintain a controlled environment, which is useful for reducing or minimizing contamination and ensuring consistent results. Finally, a system 110, e.g., a control system, controls the operation and parameters of the ion milling process, allowing for adjustments to be made for different applications and material types. The system 110 can be controlled via a touch screen display 170, which is coupled to the system 110.

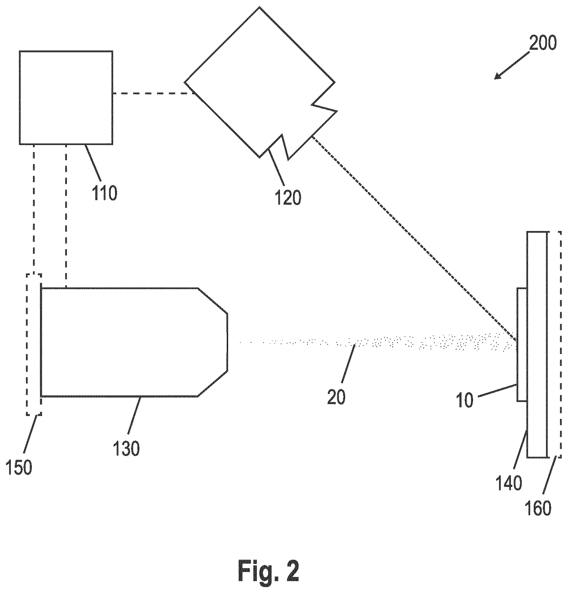

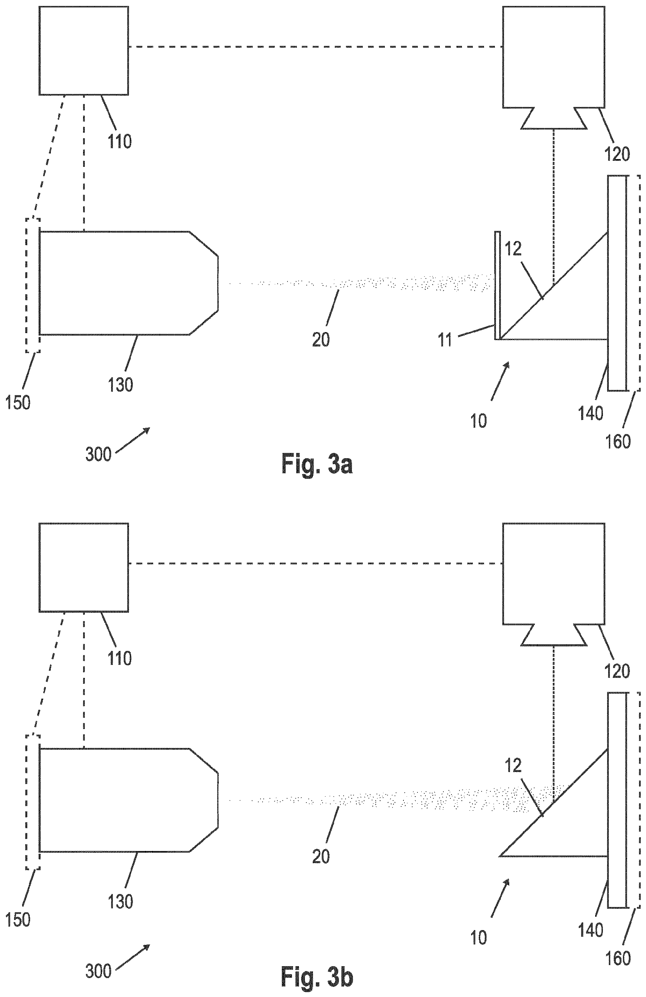

In the ion milling device 100, 300 shown in Figs. 1a, 1b and 3a/3b, a digital or hybrid microscope 120 allows a user to inspect the sample 1 that is placed on the sample stage 140, in particular while the sample is not being irradiated. To facilitate inspection of the sample, the sample stage is rotated upwards towards the microscope 120 to allow for inspection of the sample 1 and mask 3, e.g., to align the sample 1 relative to the mask 3. The system 110 uses image data from the microscope 120, which functions as an optical imaging device. Alternatively, as shown in Fig. 2, a camera 120 may be placed in the chamber of the ion milling device 100 and used to monitor the sample before and after the ion milling. As the sputtering leads to deposition of material removed from the sample on the components inside the ion milling chamber, the camera may be shielded from the sample chamber during ion milling, e.g., using a retractable shield, which may be removed periodically or occasionally to allow for monitoring of the progress of the ion milling process.

The proposed concept relates to the calibration of an ion milling device, and in particular to the determination of a position or orientation of at least one ion beam 20 relative to the sample stage 140. In this context, the position of an ion beam 20 relative to the sample stage may be the position of the point at which the ion beam intersects the sample stage, a sample mounted on the sample stage, or a calibration sample mounted on the sample stage. For example, the position of the point may be defined relative to a coordinate system defined by the sample stage 140 or a coordinate system defined by the ion milling device (which may be the same). The orientation of an ion beam 20 relative to the sample stage 140 may be an angle between an ion emitter-facing surface of the sample stage 140 and the center axis of the cone of the ion beam 20, or a vector of the center axis of the cone of the ion beam 20 in a coordinate system defined by the sample stage 140 (or by the ion milling device 100).

In the proposed concept, the position and/or orientation of the beam relative to the sample stage are determined by the system 110, using image data from the optical imaging device 120 (e.g., the microscope or camera). In particular, the system 110 is configured to obtain image data from the optical imaging device 120 of the ion milling device, with the image data showing a calibration sample 10 (shown in Figs. 2 and 3a/3b) mounted on the sample stage 140 while the calibration sample 10 is irradiated by at least one ion beam 20 emitted by the at least one ion emitter 130. The system 110 processes the image data to determine the position and/or the orientation of the at least one ion beam 20 relative to the sample stage.

The proposed concept thus uses the calibration sample to determine where the ion beam (e.g., the center axis of the ion beam) would intersect with the sample during normal operation of the ion milling device 100. During a calibration period (prior to ion milling of a sample 1), instead of the sample 1, a calibration sample 10 is mounted to the sample stage 140 (which is used both for the calibration sample 10 and for the actual sample being ion milled). The optical imaging device 120 is used to capture image data of the calibration sample while the calibration sample is irradiated by the at least one ion emitter 130, and the point (or rather area) at which the ion beam hits the calibration sample is used to determine the position and orientation (e.g., the position of the intersection, the angle, and/or the vector) of the ion beam in relation to the sample stage.

In the proposed concept, three different approaches, shown in Figs. 2, 3a and 3b, are discussed that differ with respect to the shape and configuration of the calibration sample being used and with respect to the placement of the optical imaging device. A suitable calibration sample for visualizing the ion beam can be a metal surface or glass surface that reflects the beam, as shown in Fig. 2 (with camera observation at 45° angle), a glass plate 11 (as shown in Fig. 3a) that is observed via a mirror 12, or a glass or metal surface 12 that is at an angle relative to the emitter-facing surface of the sample stage (as shown in Fig. 3b). Comparable observation of the beam spot may be ensured by reliable positioning of the optical imaging device in relation to the calibration sample (e.g., at a fixed angle of around 45° in the case of Fig. 2 or Fig. 3b, or at a position that is dependent on the reflection provided by the mirror 12 in the case of Fig. 3a, which is also 45° relative to the mirror in the case of Fig. 3a).

Fig. 2 shows a schematic diagram of a system 110 for an ion milling device 100 and of an ion milling device 100 comprising such a system 110, the sample stage 140, a camera 120 (as optical imaging device), and at least one ion emitter 130. In the example shown in Fig. 2, a planar, metal calibration sample 10 is mounted to the sample stage 140. Alternatively, the calibration sample may be a planar glass calibration sample 10. A camera 120 is placed within the sample chamber. The camera is at an approximate 45-degree angle to the planar calibration sample (i.e., to the emitter-facing surface of the calibration sample). In other words, the angle between the ion emitter-facing surface of the sample stage 140 (and thus the calibration sample) and a straight line between the optical imaging device 120 and a center point of the emitter-facing surface of the sample stage 140 may be at least 40 degrees and at most 50 degrees.

Figs. 3a and 3b show schematic diagrams of a system 110 for an ion milling device and of an ion milling device 100 comprising such a system 110, the sample stage 140, a digital or hybrid microscope 120 (as optical imaging device), and at least one ion emitter 130. In the example shown in Fig. 3a, a more complex calibration sample is used to support the use of the digital or hybrid microscope 120, which is used for aligning the sample 1 with the mask 3 (see Figs. 1a and 1b). The calibration sample comprises a glass plate 11 that is to be irradiated by the ion beam 20 emitted by the at least one ion emitter 130. In contrast to Fig. 2 and 3b, where the reaction of the calibration sample to the ion beam can be directly observed by camera 120, in Fig. 3a, the microscope 120 observes the reaction via a mirror 12 that is at a 45-degree angle to the glass plate. Thus, the mirror 12 is configured to reflect light of the visually perceivable reaction of the glass plate to the irradiation by the ion beam towards the optical imaging device (microscope 120) of the ion milling device 100. In turn, the optical imaging device 120 is positioned to generate the image data of light reflected by the mirror 12 of the calibration sample 10 mounted on the sample stage. In Fig. 3b, a modified version of this calibration sample is used, in which the glass plate 11 is omitted. Instead, the ion beam irradiates the surface 12 (which may be a glass surface or metal surface). This surface 12 is configured to emit light of a visually perceivable reaction of the surface to the irradiation by an ion beam towards the optical imaging device 120. In particular, similar to the mirror 12, it is at a 45-degree angle to the emitter-facing surface of the sample stage. In more general terms, the surface may be arranged such that, when the calibration sample is mounted to the sample stage, the surface is at an angle of between 40 degrees and 50 degrees relative to an ion emitter-facing surface of the sample stage. Again, the optical imaging device 120 is positioned to generate image data of the light emitted by the surface.

The subsequent image processing and calibration of the relative position are similar for both configurations shown in Figs. 2 and 3a/3b.

In the proposed optical imaging device-based alignment of the ion beam, the ion beam spot is observed on a material with the optical imaging device 120, e.g., at one or more positions in the ion milling device. The ion beam spot may then be used to deduce the ion beam axis from the image data. This enables the exact positioning of the sample (and mask edge) in the ion milling device according to the ion beam.

When an Argon ion beam hits the (metal or glass) surface of the calibration sample, a beam spot (e.g., a green beam spot in case of a metal calibration sample) is visible that contains information about the intensity distribution of the ion beam. This beam spot is a visually perceivable reaction of the calibration sample 10 to the at least one ion beam 20.

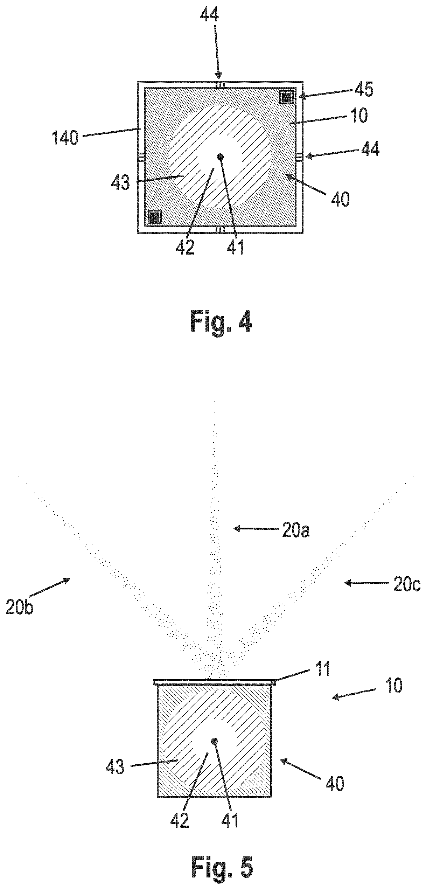

Fig. 4 shows a schematic diagram of a calibration sample 10 being mounted on a sample stage 140. In the middle of the calibration sample, the visually perceivable reaction 40 of the calibration sample 10 to an ion beam 20 is visible. The visually perceivable reaction 40, i.e., the reaction of the material of the calibration sample 10 to the ion beam that can be perceived by the optical imaging device 120, shows an intensity distribution with a large intensity towards the circular center 42 (saturating the optical imaging device 120) that drops off towards the periphery of the calibration sample 10, as indicated by the ring-shaped area 43 surrounding the center 42. In the middle of the center 42, the midpoint 41 of the intensity distribution can be found.

The intensity distribution 42, 43 can be used to determine where the center axis of the ion beam(s) hits the calibration sample. Thus, the system may be configured to determine the position and/or orientation of the at least one ion beam based on the intensity distribution of the visually perceivable reaction 40 of the calibration sample to the at least one ion beam 20. The intensity distribution of the reaction provides a spatial map of the ion beam's interaction with the calibration sample 10. By processing the intensity distribution (e.g., identifying the peak as the midpoint 41), the position of the beam's impact can be determined, as the distribution correlates directly with where the beam strikes the sample.

The position of the ion beam impact can be determined by the system 110 by identifying the peak or midpoint (e.g., centroid) of the intensity distribution, as the highest intensity typically corresponds to the beam's location. In some examples, the system 110 may prompt the user to manually select the beam midpoint in the image data, e.g., using the touch screen display 170. Alternatively, or additionally, the system may be configured to use thresholding, edge detection, or centroid calculation to determine the midpoint of the intensity distribution. Alternatively, or additionally, the system may use a trained machine-learning model to determine the midpoint of the intensity distribution. In other words, the system 110 may be configured to process the image data using a machine learning model that is trained to output the position of the midpoint 41 of the intensity distribution in the image data. For example, the machine learning model may be trained, using supervised learning and using training samples comprising image data with intensity distributions as input data and labels indicating the position of the respective midpoint of the intensity distribution as desired output, to output the position of the midpoint 41 for a given instance of image data being input into the machine learning model. In both cases, the system 110 may be configured to determine the midpoint 41 of the intensity distribution and use the position of the midpoint to determine the position and/or orientation of the at least one ion beam.

To facilitate determining the position and orientation of the at least one beam 20 in a coordinate system, e.g., in the coordinate system of the ion milling device 100 or of the sample stage 140 (which may be the same coordinate system), positional reference markers may be used. For example, as shown in Fig. 4, the image data may show at least one positional reference marker 44 of the sample stage or at least one positional reference marker 45 of the calibration sample. For example, one- or two-dimensional visual markers may be used as positional reference markers, helping the system to determine the position of the midpoint relative to the sample stage or calibration sample. The system 110 may be configured to determine the position and/or orientation of the at least one ion beam relative to the sample stage based on the at least one positional reference marker of the sample stage or calibration sample.

When the position and/or orientation of the ion beam(s) is known, it may be used to improve the targeting of the ion beam(s), e.g., to ensure that the midpoint of the ion beam(s) hit the edge of the mask (or slightly above the edge of the mask), which is feasible, as the extent of the mask 3 relative to the sample stage 140 is known, as shown in Figs. 1a and 1b. The position at which the ion beam intersects with the mask 3 (and sample 1) can be adjusted by at least one of a) adjusting the position and/or orientation (i.e., tilt) of the ion emitter(s) 130, or b) adjusting the position and/or orientation of the sample stage 140. Both can be adjusted either automatically, e.g., using a servo motor-based ion emitter positioning mechanism 150 or a servo motor-based sample stage positioning mechanism 160, or manually, e.g., using adjustment screws that are manually turned by the user. For example, the system may be configured to control the ion emitter positioning mechanism 150 to adjust at least one of a position or orientation of the at least one ion emitter 130 based on the position or orientation of the at least one ion beam emitted by the at least one ion emitter relative to the sample stage. For example, if the ion milling device may comprise two or more ion emitters 130, the system 110 may control two or more ion emitter positioning mechanisms 150 to adjust the position and/or orientation of the two or more ion emitters 130 based on the position or orientation of respective ion beams emitted by the respective ion emitters. In the case of adjusting the position and/or orientation of the sample stage, the system may be configured to control the sample stage positioning mechanism 160 to adjust at least one of a position or orientation of the sample stage based on the position or orientation of the at least one ion beam emitted by the at least one ion emitter relative to the sample stage. For example, the respective position(s) or orientation(s) may be adjusted such that the ion beam(s) target the edge (or slightly above the edge) of the mask 3.

As an alternative to automatically adjusting the position or orientation of the ion emitter(s) 130 and/or the sample stage 140, the user may be guided to make the adjustments. For example, the system may be configured to provide a display signal for the display device 170 of the ion milling device. For example, in case of adjusting the position and/or orientation of the ion emitter(s) 130, the display signal may comprise information on how to adjust the position and/or orientation of the at least one ion emitter. In case of adjusting the position and/or orientation of the sample stage 140, the display signal may comprise information on how to adjust the position and/or orientation of the sample stage. For example, the information on how to adjust the position and/or orientation may comprise information (e.g., images, such as arrows) on which screws to use and how many rotations of the respective screws are to be performed. Again, the information on how to adjust the position and/or orientation of the at least one ion emitter or sample stage may be based on the position and/or orientation of the at least one ion beam. For example, the information on how to adjust the position and/or orientation of the at least one ion emitter or sample stage may be provided such that, as a result of the manual adjustment, the ion beam(s) target the edge (or slightly above the edge) of the mask 3.

In the following, two example workflows for using the proposed concept are provided. The first workflow relates to an alignment process for a fixed stage position. The measurement and analysis may be done in the course of a machine calibration. First, the calibration sample is mounted at a desired milling sample position. Then, the ion source is started with calibration settings (e.g., with an adjusted (lower) beam intensity), and the beam spot becomes visible on the calibration sample and is observed by the optical imaging device. The beam midpoint 41 may be detected by the system 110 by examining the intensity distribution (e.g., manually or algorithmically) of the image in the region of the beam spot at the sample position. Finally, the stage is adjusted. This can be done by moving the stage (manually or automatically) to a position where the sample region of interest/mask edge will be positioned at the beam midpoint. To aid the user, this position and the extracted beam midpoint can be displayed in the camera image in real time. Alternatively, or additionally, the system may calculate the position of the beam midpoint at the given stage position and translate the position of the beam midpoint to stage positioning parameters for the real (not calibration) sample. Then, the real sample 1 may be inserted, and the stage and sample position may be adjusted with the extracted information to ensure an improved or optimal overlap of the sample 1 with the ion beam 20. The adjustment can be performed manually or automatically if possible (e.g., using a motorized stage).

The second workflow relates to an alignment process for a stage position that is variable in the beam axis. Also in the second workflow, the measurement and analysis may be done in the course of a machine calibration. First, the calibration sample is mounted at a desired milling sample position. Then, the ion source is started with calibration settings (e.g., with an adjusted (lower) beam intensity), and the beam spot becomes visible on the calibration sample and is observed by the optical imaging device. The beam midpoint 41 may be detected by the system 100 by examining the intensity distribution (e.g., manually or algorithmically) of the image in the region of the beam spot at the sample position. Then, the calibration sample is moved to or away from the beam. Correct alignment of the calibration sample with the camera is ensured to establish positional reference. The beam midpoint may be detected a second time by the system 100 by examining the intensity distribution (e.g., manually or algorithmically) of the image in the region of the beam spot in the second position. Then, the system 110 may calculate the beam axis in the vacuum chamber of the ion milling device.

Thus, two positions may be determined at which the ion beam hits the calibration sample for two different positions of the sample stage. For example, the system 110 may be configured to control the sample stage positioning mechanism 160 (e.g., the motorized sample stage) to adjust the distance between the sample stage 140 and the at least one ion emitter 130, and obtain at least a first frame of image data showing the calibration sample at a first distance from the at least one ion emitter and a second frame of image data showing the calibration sample at a second distance from the at least one ion emitter. Alternatively, if the ion milling device does not have a motorized sample stage 140, the position of the sample stage may be adjusted manually. In other words, the system may be configured to obtain at least the first frame of image data showing the calibration sample at the first distance from the at least one ion emitter prior to a manual adjustment of the sample stage and the second frame of image data showing the calibration sample at the second distance from the at least one ion emitter after the manual adjustment of the sample stage. In this case, the system 110 may be configured to determine the position of the sample stage, e.g., using the positional markers 44 on the sample stage, e.g., based on a known relationship of pixels of the image data and real-world coordinates. In both cases, the system 110 may be configured to determine the orientation of the at least one ion beam based on the first and second frames of image data. In particular, the system 110 may be configured to determine the respective midpoints of the respective visually perceivable reaction 40 of the calibration sample, and plot a straight line through the midpoints to determine the orientation of the ion beam(s). In other words, the system 110 may be configured to determine the orientation of the at least one ion beam by determining a straight line between midpoints 41 of the respective intensity distributions of a visually perceivable reaction 40 of the calibration sample to the at least one ion beam shown in the first and second frames.

When the orientation of the ion beam (i.e., the beam axis) is determined, an improved or optimal sample position may be calculated. For example, as part of the second workflow, at the chosen stage position for the planned cross-sectioning process, the system may calculate an improved or optimal sample position (lateral and height) that may yield an improved or optimal overlap of the sample region of interest with the ion beam. Then, the real sample may be inserted, and the stage and sample position may be adjusted using the extracted information (orientation of the ion beam) to ensure an improved or optimal overlap of the sample with the ion beam. Again, the adjustment can be performed manually or automatically if possible (motorized stage).

In some examples, as shown in Fig. 5, the ion milling device 100 may comprise multiple ion emitters 130. Fig. 5 shows a schematic diagram of a glass plate 11 of a calibration sample 10 being irradiated by three ion emitters, using three ion beams 20a, 20b, 20c. Thus, the proposed concept may also be used for alignment of multiple ion beams. The optical imaging device-based alignment can also be used to align several ion beams 20a, 20b, 20c. For that, the analysis of the beam spots would be done sequentially for each ion beam. Thus, only one of the ion beams 20a, 20b, 20c might be on at a time, with the remaining two being off. In this case, the visually perceivable reaction 40 (beam spot) to only one of the ion beams would be visible in Fig. 5. With the positional information deduced as described in the above workflows and examples, the positioning of the ion sources may be adjusted to ensure an improved overlap of the different beams. Accordingly, the system 110 may be configured to, if the ion milling device 100 comprises two or more ion emitters 130, process two or more frames of image data, with each frame of image data showing the irradiation of the calibration sample by a single one of the ion emitters. The system 110 may be configured to process the frames of image data separately to determine the position and/or orientation of the two or more ion beams 20a, 20b, 20c emitted by the two or more ion emitters relative to the sample stage, e.g., as outlined in workflows 1 and 2.

In an alternative implementation, a single frame of image data (being based on the ion beams of multiple ion emitters) may suffice for determining the position of multiple ion beams, and multiple frames each showing the ion beams of multiple ion emitters may be used to determine the orientation of the respective ion beams. For example, the system 110 may be configured to, if the ion milling device comprises two or more ion emitters, process at least one frame of image data showing the irradiation of the calibration sample by the two or more ion emitters. The system 110 may be configured to process the at least one frame of image data to determine the position and/or orientation of the two or more ion beams 20a, 20b, 20c emitted by the two or more ion emitters relative to the sample stage. For example, in this case, the machine learning model may not only be used to determine the midpoints of the respective ion beams, but also estimate the angle at which the ion beams have hit the respective surface being irradiated. For example, the machine learning model may be trained to output, e.g., in addition to the position of the midpoint, information on an angle at which the ion beam has irradiated the respective surface. For example, in case of two or more ion emitters, the machine learning model may be trained to output which of the two or more ion emitters has likely emitted the ion beam associated with the midpoint (as classification result), with the source of the ion beam being indicative of the angle. For example, the machine learning model may use the distortion of the intensity distribution to determine which of the two or more ion emitters has likely emitted the ion beam associated with the midpoint. In this case, the desired output of the training data may further comprise a desired classification result (emitter 1, 2 or 3...) of the intensity distribution associated with the respective midpoint. Alternatively, which of the emitters has emitted a given intensity distribution may be determined using classical image processing techniques, e.g., based on the shape of the respective intensity distribution.

The proposed concept may ensure an improved etching performance through efficient use of the ion beam. It can be easily handled by the user, as the alignment is aided by the system (e.g., software). For example, the existing camera (e.g., microscope) and stage may be used together with a special calibration sample.

In general, the system 110 may be a computer system. The system 110 comprises one or more processors 114 and one or more storage devices 116. Optionally, the system 110 further comprises one or more interfaces 112. The one or more processors 114 are coupled to the one or more storage devices 116 and to the one or more interfaces 112. In general, the functionality of the system 110 may be provided by the one or more processors 114, in conjunction with the one or more interfaces 112 (for exchanging data/information with one or more other components of the ion milling device 100 and outside the ion milling device 100, such as the optical imaging device 120, the ion emitter 130, the positioning device(s) 150, 160, and/or the touch-screen display 170), and with the one or more storage devices 116 (for storing information, such as machine-readable instructions of a computer program being executed by the one or more processors). In general, the functionality of the one or more processors 114 may be implemented by the one or more processors 114 executing machine-readable instructions. Accordingly, any feature ascribed to the one or more processors 114 may be defined by one or more instructions of a plurality of machine-readable instructions. The system 110 may comprise the machine-readable instructions, e.g., within the one or more storage devices 116.

In some examples, the system 110 is configured to provide a user interface with information on how to adjust the position and/or orientation of the ion emitter(s) or of the sample stage. For example, the system 110 may be configured to output a display signal to a touch-screen display 170 or a display 170 of the ion milling device 100, with the display signal comprising the user interface. For example, the display signal may be a signal for driving (e.g., controlling) the respective display. For example, the display signal may comprise video data and/or control instructions for driving the display. For example, the display signal may be provided via one of the one or more interfaces 112 of the system 110. Accordingly, the system 110 may comprise a video interface 112 that is suitable for providing the display signal to the display device 170 of the ion milling system 100.

In the proposed ion milling device 100, optical imaging sensor(s) of the optical imaging device 120 are used to provide the aforementioned image data. Accordingly, the optical imaging sensor(s), which may be part of the optical imaging device 120 (e.g., of the microscope or camera), may be configured to generate the image data. For example, the optical imaging sensor(s) of the optical imaging device 120 or camera may comprise or be an APS (Active Pixel Sensor)-based imaging sensor or a CCD (Charge-Coupled-Device)-based imaging sensor. For example, in APS-based imaging sensors, light is recorded at each pixel using a photodetector and an active amplifier of the pixel. APS-based imaging sensors are often based on CMOS (Complementary Metal-Oxide-Semiconductor) or S-CMOS (Scientific CMOS) technology. In CCD-based imaging sensors, incoming photons are converted into electron charges at a semiconductor-oxide interface, which are subsequently moved between capacitive bins in the imaging sensor by circuitry of the imaging sensor to perform the imaging. For example, the system 110 may be configured to obtain the image data from the optical imaging device 120, for instance, by receiving the image data from the optical imaging device 120 or by reading out the image data from the optical imaging device 120.

The one or more interfaces 112 of the system 110 may correspond to one or more inputs and/or outputs for receiving and/or transmitting information, which may be in digital (bit) values according to a specified code, within a module, between modules, or between modules of different entities. For example, the one or more interfaces 112 may comprise interface circuitry configured to receive and/or transmit information. The one or more processors 114 of the system 110 may be implemented using one or more processing units, one or more processing devices, or any means for processing, such as a processor, a computer, or a programmable hardware component operable with accordingly adapted software. In other words, the described function of the one or more processors 114 may also be implemented in software, which is then executed on one or more programmable hardware components. Such hardware components may comprise a general-purpose processor, a Digital Signal Processor (DSP), a micro-controller, etc. The one or more storage devices 116 of the system 110 may comprise at least one element of the group of a computer-readable storage medium, such as a magnetic or optical storage medium, e.g., a hard disk drive, a flash memory, a Floppy-Disk, Random Access Memory (RAM), Programmable Read Only Memory (PROM), Erasable Programmable Read Only Memory (EPROM), an Electronically Erasable Programmable Read Only Memory (EEPROM), or a network storage.

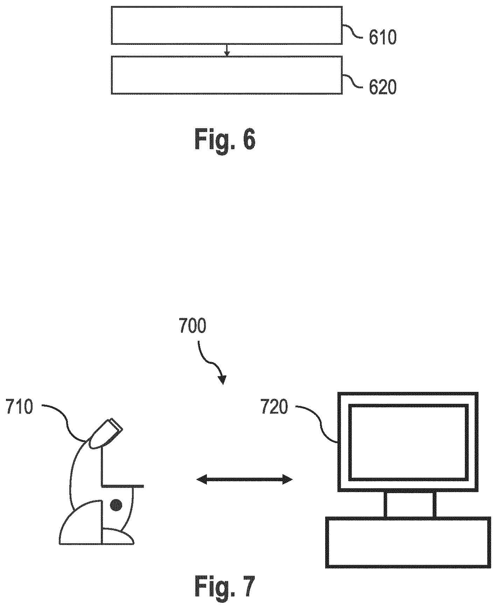

More details and aspects of the ion milling device 100 and the system 110 are mentioned in connection with the proposed concept or one or more examples described above or below (e.g., Figs. 6 to 7). The ion milling device 100 and the system 110 may comprise one or more additional optional features corresponding to one or more aspects of the proposed concept or one or more examples described above or below.

Fig. 6 shows a flowchart of an example of a corresponding method for an ion milling device, such as the ion milling device 100, 200, 300 of Figs. 1a to 5. Features discussed in connection with the system 110 and/or ion milling device 100 of Figs. 1a to 5 may likewise be included in the corresponding method of Fig. 6.

The method comprises obtaining 610 image data of (e.g., from) an optical imaging device of the ion milling device. The image data shows a calibration sample mounted on a sample stage while the calibration sample is irradiated by at least one ion emitter. The method comprises processing 620 the image data to determine at least one of a position or orientation of at least one ion beam emitted by the at least one ion emitter relative to the sample stage.

More details and aspects of the method are mentioned in connection with the proposed concept or one or more examples described above or below (e.g., Figs. 1a to 5, and 7). The method may comprise one or more additional optional features corresponding to one or more aspects of the proposed concept or one or more examples described above or below.

As used herein the term "and/or" includes any and all combinations of one or more of the associated listed items and may be abbreviated as "/".

Although some aspects have been described in the context of an apparatus, it is clear that these aspects also represent a description of the corresponding method, where a block or device corresponds to a method step or a feature of a method step. Analogously, aspects described in the context of a method step also represent a description of a corresponding block or item or feature of a corresponding apparatus.

Some embodiments relate to an optical imaging device, such as a microscope or camera, that is part of or connected to a system as described in connection with one or more of the Figs. 1a to 6. Fig. 7 shows a schematic illustration of a system 700 configured to perform a method described herein. The system 700 comprises an optical imaging device 710, such as a microscope or camera, and a computer system 720. The optical imaging device 710 is configured to take images and is connected to the computer system 720. The computer system 720 is configured to execute at least a part of a method described herein. The computer system 720 may be configured to execute a machine learning algorithm. The computer system 720 and optical imaging device 710 may be separate entities but can also be integrated together in one common housing. The computer system 720 may be part of a central processing system of the optical imaging device 710 and/or the computer system 720 may be part of a subcomponent of the optical imaging device 710, such as a sensor, an actor, a camera or an illumination unit, etc. of the optical imaging device 710.

The computer system 720 may be a local computer device (e.g. personal computer, laptop, tablet computer or mobile phone) with one or more processors and one or more storage devices or may be a distributed computer system (e.g. a cloud computing system with one or more processors and one or more storage devices distributed at various locations, for example, at a local client and/or one or more remote server farms and/or data centers). The computer system 720 may comprise any circuit or combination of circuits. In one embodiment, the computer system 720 may include one or more processors which can be of any type. As used herein, processor may mean any type of computational circuit, such as but not limited to a microprocessor, a microcontroller, a complex instruction set computing (CISC) microprocessor, a reduced instruction set computing (RISC) microprocessor, a very long instruction word (VLIW) microprocessor, a graphics processor, a digital signal processor (DSP), multiple core processor, a field programmable gate array (FPGA), for example, of a microscope or a microscope component (e.g. camera) or any other type of processor or processing circuit. Other types of circuits that may be included in the computer system 720 may be a custom circuit, an application-specific integrated circuit (ASIC), or the like, such as, for example, one or more circuits (such as a communication circuit) for use in wireless devices like mobile telephones, tablet computers, laptop computers, two-way radios, and similar electronic systems. The computer system 720 may include one or more storage devices, which may include one or more memory elements suitable to the particular application, such as a main memory in the form of random access memory (RAM), one or more hard drives, and/or one or more drives that handle removable media such as compact disks (CD), flash memory cards, digital video disk (DVD), and the like. The computer system 720 may also include a display device, one or more speakers, and a keyboard and/or controller, which can include a mouse, trackball, touch screen, voice-recognition device, or any other device that permits a system user to input information into and receive information from the computer system 720.

Some or all of the method steps may be executed by (or using) a hardware apparatus, like for example, a processor, a microprocessor, a programmable computer or an electronic circuit. In some embodiments, some one or more of the most important method steps may be executed by such an apparatus.

Depending on certain implementation requirements, embodiments of the invention can be implemented in hardware or in software. The implementation can be performed using a non-transitory storage medium such as a digital storage medium, for example a floppy disc, a DVD, a Blu-Ray, a CD, a ROM, a PROM, and EPROM, an EEPROM or a FLASH memory, having electronically readable control signals stored thereon, which cooperate (or are capable of cooperating) with a programmable computer system such that the respective method is performed. Therefore, the digital storage medium may be computer readable.

Some embodiments according to the invention comprise a data carrier having electronically readable control signals, which are capable of cooperating with a programmable computer system, such that one of the methods described herein is performed.

Generally, embodiments of the present invention can be implemented as a computer program product with a program code, the program code being operative for performing one of the methods when the computer program product runs on a computer. The program code may, for example, be stored on a machine readable carrier.

Other embodiments comprise the computer program for performing one of the methods described herein, stored on a machine readable carrier.

In other words, an embodiment of the present invention is, therefore, a computer program having a program code for performing one of the methods described herein, when the computer program runs on a computer.

A further embodiment of the present invention is, therefore, a storage medium (or a data carrier, or a computer-readable medium) comprising, stored thereon, the computer program for performing one of the methods described herein when it is performed by a processor. The data carrier, the digital storage medium or the recorded medium are typically tangible and/or non-transitionary. A further embodiment of the present invention is an apparatus as described herein comprising a processor and the storage medium.

A further embodiment of the invention is, therefore, a data stream or a sequence of signals representing the computer program for performing one of the methods described herein. The data stream or the sequence of signals may, for example, be configured to be transferred via a data communication connection, for example, via the internet.

A further embodiment comprises a processing means, for example, a computer or a programmable logic device, configured to, or adapted to, perform one of the methods described herein.

A further embodiment comprises a computer having installed thereon the computer program for performing one of the methods described herein.

A further embodiment according to the invention comprises an apparatus or a system configured to transfer (for example, electronically or optically) a computer program for performing one of the methods described herein to a receiver. The receiver may, for example, be a computer, a mobile device, a memory device or the like. The apparatus or system may, for example, comprise a file server for transferring the computer program to the receiver.

In some embodiments, a programmable logic device (for example, a field programmable gate array) may be used to perform some or all the functionalities of the methods described herein. In some embodiments, a field programmable gate array may cooperate with a microprocessor to perform one of the methods described herein. Generally, the methods are preferably performed by any hardware apparatus.

Embodiments may be based on using a machine-learning model or machine-learning algorithm. Machine learning may refer to algorithms and statistical models that computer systems may use to perform a specific task without using explicit instructions, instead relying on models and inference. For example, in machine-learning, instead of a rule-based transformation of data, a transformation of data may be used, that is inferred from an analysis of historical and/or training data. For example, the content of images may be analyzed using a machine-learning model or using a machine-learning algorithm. In order for the machine-learning model to analyze the content of an image, the machine-learning model may be trained using training images as input and training content information as output. By training the machine-learning model with a large number of training images and/or training sequences (e.g. words or sentences) and associated training content information (e.g. labels or annotations), the machine-learning model "learns" to recognize the content of the images, so the content of images that are not included in the training data can be recognized using the machine-learning model. The same principle may be used for other kinds of sensor data as well: By training a machine-learning model using training sensor data and a desired output, the machine-learning model "learns" a transformation between the sensor data and the output, which can be used to provide an output based on non-training sensor data provided to the machine-learning model. The provided data (e.g. sensor data, meta data and/or image data) may be preprocessed to obtain a feature vector, which is used as input to the machine-learning model.

Machine-learning models may be trained using training input data. The examples specified above use a training method called "supervised learning". In supervised learning, the machine-learning model is trained using a plurality of training samples, wherein each sample may comprise a plurality of input data values, and a plurality of desired output values, i.e. each training sample is associated with a desired output value. By specifying both training samples and desired output values, the machine-learning model "learns" which output value to provide based on an input sample that is similar to the samples provided during the training. Apart from supervised learning, semi-supervised learning may be used. In semi-supervised learning, some of the training samples lack a corresponding desired output value. Supervised learning may be based on a supervised learning algorithm (e.g. a classification algorithm, a regression algorithm or a similarity learning algorithm. Classification algorithms may be used when the outputs are restricted to a limited set of values (categorical variables), i.e. the input is classified to one of the limited set of values. Regression algorithms may be used when the outputs may have any numerical value (within a range). Similarity learning algorithms may be similar to both classification and regression algorithms but are based on learning from examples using a similarity function that measures how similar or related two objects are. Apart from supervised or semi-supervised learning, unsupervised learning may be used to train the machine-learning model. In unsupervised learning, (only) input data might be supplied and an unsupervised learning algorithm may be used to find structure in the input data (e.g. by grouping or clustering the input data, finding commonalities in the data). Clustering is the assignment of input data comprising a plurality of input values into subsets (clusters) so that input values within the same cluster are similar according to one or more (pre-defined) similarity criteria, while being dissimilar to input values that are included in other clusters.

Reinforcement learning is a third group of machine-learning algorithms. In other words, reinforcement learning may be used to train the machine-learning model. In reinforcement learning, one or more software actors (called "software agents") are trained to take actions in an environment. Based on the taken actions, a reward is calculated. Reinforcement learning is based on training the one or more software agents to choose the actions such, that the cumulative reward is increased, leading to software agents that become better at the task they are given (as evidenced by increasing rewards).

Furthermore, some techniques may be applied to some of the machine-learning algorithms. For example, feature learning may be used. In other words, the machine-learning model may at least partially be trained using feature learning, and/or the machine-learning algorithm may comprise a feature learning component. Feature learning algorithms, which may be called representation learning algorithms, may preserve the information in their input but also transform it in a way that makes it useful, often as a pre-processing step before performing classification or predictions. Feature learning may be based on principal components analysis or cluster analysis, for example.

In some examples, anomaly detection (i.e. outlier detection) may be used, which is aimed at providing an identification of input values that raise suspicions by differing significantly from the majority of input or training data. In other words, the machine-learning model may at least partially be trained using anomaly detection, and/or the machine-learning algorithm may comprise an anomaly detection component.

In some examples, the machine-learning algorithm may use a decision tree as a predictive model. In other words, the machine-learning model may be based on a decision tree. In a decision tree, observations about an item (e.g. a set of input values) may be represented by the branches of the decision tree, and an output value corresponding to the item may be represented by the leaves of the decision tree. Decision trees may support both discrete values and continuous values as output values. If discrete values are used, the decision tree may be denoted a classification tree, if continuous values are used, the decision tree may be denoted a regression tree.

Association rules are a further technique that may be used in machine-learning algorithms. In other words, the machine-learning model may be based on one or more association rules. Association rules are created by identifying relationships between variables in large amounts of data. The machine-learning algorithm may identify and/or utilize one or more relational rules that represent the knowledge that is derived from the data. The rules may e.g. be used to store, manipulate or apply the knowledge.

Machine-learning algorithms are usually based on a machine-learning model. In other words, the term "machine-learning algorithm" may denote a set of instructions that may be used to create, train or use a machine-learning model. The term "machine-learning model" may denote a data structure and/or set of rules that represents the learned knowledge (e.g. based on the training performed by the machine-learning algorithm). In embodiments, the usage of a machine-learning algorithm may imply the usage of an underlying machine-learning model (or of a plurality of underlying machine-learning models). The usage of a machine-learning model may imply that the machine-learning model and/or the data structure/set of rules that is the machine-learning model is trained by a machine-learning algorithm.

For example, the machine-learning model may be an artificial neural network (ANN). ANNs are systems that are inspired by biological neural networks, such as can be found in a retina or a brain. ANNs comprise a plurality of interconnected nodes and a plurality of connections, so-called edges, between the nodes. There are usually three types of nodes, input nodes that receiving input values, hidden nodes that are (only) connected to other nodes, and output nodes that provide output values. Each node may represent an artificial neuron. Each edge may transmit information, from one node to another. The output of a node may be defined as a (non-linear) function of its inputs (e.g. of the sum of its inputs). The inputs of a node may be used in the function based on a "weight" of the edge or of the node that provides the input. The weight of nodes and/or of edges may be adjusted in the learning process. In other words, the training of an artificial neural network may comprise adjusting the weights of the nodes and/or edges of the artificial neural network, i.e. to achieve a desired output for a given input.

Alternatively, the machine-learning model may be a support vector machine, a random forest model or a gradient boosting model. Support vector machines (i.e. support vector networks) are supervised learning models with associated learning algorithms that may be used to analyze data (e.g. in classification or regression analysis). Support vector machines may be trained by providing an input with a plurality of training input values that belong to one of two categories. The support vector machine may be trained to assign a new input value to one of the two categories. Alternatively, the machine-learning model may be a Bayesian network, which is a probabilistic directed acyclic graphical model. A Bayesian network may represent a set of random variables and their conditional dependencies using a directed acyclic graph. Alternatively, the machine-learning model may be based on a genetic algorithm, which is a search algorithm and heuristic technique that mimics the process of natural selection.

### List of reference Signs

- 1: Sample
- 2: Sample holder
- 3: Mask
- 10: Calibration sample
- 11: Glass plate
- 12: Mirror
- 40: Visually perceivable reaction
- 41: Midpoint
- 42: Center of beam
- 43: Periphery of beam
- 44: Positional marker on sample stage
- 45: Positional marker on calibration sample
- 20: Ion beam
- 100: Ion milling device
- 110: System
- 120: Optical imaging device, camera, microscope
- 130: Ion emitter
- 140: Sample stage
- 150: Ion emitter positioning mechanism
- 160: Sample stage positioning mechanism
- 170: Touch-screen display
- 610: Obtaining image data
- 620: Processing the image data to determine the position and/or orientation of at least one ion beam
- 700: System
- 710: Optical imaging device
- 720: Computer system

## Claims

1. A system (110, 720) for an ion milling device (100, 200, 300), the system comprising one or more processors and one or more storage devices, wherein the system is configured to:
obtain image data of an optical imaging device (120, 710) of the ion milling device, the image data showing a calibration sample mounted on a sample stage (140) while the calibration sample (10) is irradiated by at least one ion beam (20, 20a, 20b, 20c) emitted by at least one ion emitter (130); and
process the image data to determine at least one of a position or orientation of the at least one ion beam (20) relative to the sample stage.

2. The system according to claim 1, wherein the image data shows at least one positional reference marker (44, 45) of the sample stage or calibration sample, with the system being configured to determine the position and/or orientation of the at least one ion beam relative to the sample stage based on the at least one positional reference marker of the sample stage or calibration sample.

3. The system according to one of the claims 1 or 2, wherein the system is configured to determine the position and/or orientation of the at least one ion beam based on an intensity distribution of a visually perceivable reaction (40) of the calibration sample to the at least one ion beam.

4. The system according to claim 3, wherein the system is configured to determine the midpoint (41) of the intensity distribution and use the position of the midpoint to determine the position and/or orientation of the at least one ion beam.
and/or wherein the system is configured to process the image data using a machine learning model trained to output the position of a midpoint (41) of the intensity distribution in the image data.

5. The system according to one of the claims 1 to 5, wherein the system is configured to, if the ion milling device comprises two or more ion emitters, process two or more frames of image data, each frame of image data showing the irradiation of the calibration sample by a single one of the ion emitters, and process the frames of image data separately to determine the position and/or orientation of the two or more ion beams (20a, 20b, 20c) emitted by the two or more ion emitters relative to the sample stage,
or wherein the system is configured to, if the ion milling device comprises two or more ion emitters, process at least one frame of image data showing the irradiation of the calibration sample by the two or more ion emitters, and process the at least one frame of image data to determine the position and/or orientation of the two or more ion beams (20a, 20b, 20c) emitted by the two or more ion emitters relative to the sample stage.

6. The system according to one of the claims 1 to 5, wherein the system is configured to control an ion emitter positioning mechanism (150) to adjust at least one of a position or orientation of the at least one ion emitter (130) based on the position or orientation of the at least one ion beam emitted by the at least one ion emitter relative to the sample stage,
or wherein the system is configured to provide a display signal for a display device of the ion milling device, the display signal comprising information on how to adjust the position and/or orientation of the at least one ion emitter, with the information on how to adjust the position and/or orientation of the at least one ion emitter being based on the position and/or orientation of the at least one ion beam

7. The system according to claim 6, wherein the system is configured to, if the ion milling device comprises two or more ion emitters, control at least one ion emitter positioning mechanism to adjust the position and/or orientation of the two or more ion emitters based on the position or orientation of respective ion beams emitted by the respective ion emitters.

8. The system according to one of the claims 1 to 7, wherein the system is configured to control a sample stage positioning mechanism (160) to adjust at least one of a position or orientation of the sample stage based on the position or orientation of the at least one ion beam emitted by the at least one ion emitter relative to the sample stage,
or wherein the system is configured to provide a display signal for a display device of the ion milling device, the display signal comprising information on how to adjust the position and/or orientation of the sample stage, with the information on how to adjust the position and/or orientation of the sample stage being based on the position and/or orientation of the at least one ion beam.

9. The system according to one of the claims 1 to 8, wherein the system is configured to control a sample stage positioning mechanism (160) to adjust a distance between the sample stage and the at least one ion emitter, obtain at least a first frame of image data showing the calibration sample at a first distance from the at least one ion emitter and a second frame of image data showing the calibration sample at a second distance from the at least one ion emitter, and determine the orientation of the at least one ion beam based on the first and second frames of image data,
or wherein the system is configured to obtain at least a first frame of image data showing the calibration sample at a first distance from the at least one ion emitter prior to a manual adjustment of the sample stage and a second frame of image data showing the calibration sample at a second distance from the at least one ion emitter after the manual adjustment of the sample stage, and determine the orientation of the at least one ion beam based on the first frame and second frame of image data.

10. A calibration sample (10) for an ion milling device, comprising:
a glass plate (11) to be irradiated by an ion beam emitted by an ion emitter of the ion milling device; and
a mirror (12) configured to reflect light of a visually perceivable reaction of the glass plate to the irradiation by the ion beam towards an optical imaging device of the ion milling device.

11. A calibration sample (10) for an ion milling device, comprising:
a surface (12) configured to emit light of a visually perceivable reaction of the surface to the irradiation by an ion beam towards an optical imaging device of the ion milling device, wherein the surface is arranged such that, when the calibration sample is mounted to the sample stage, the surface is at an angle of between 40 degrees and 50 degrees relative to an ion emitter-facing surface of the sample stage.

12. An ion milling device (100) comprising the system (110) according to one of the claims 1 to 9, a sample stage (140), an optical imaging device (120), and at least one ion emitter (130).

13. The ion milling device according to claim 12, wherein the sample stage is provided for use with the calibration sample and for use with samples to be milled using the ion milling device,
and/or wherein an angle between an ion emitter-facing surface of the sample stage (140) and a straight line between the optical imaging device and a center point of the emitter-facing surface of the sample stage is at least 40 degrees and at most 50 degrees, or wherein the optical imaging device is positioned to generate image data of light reflected by a mirror (12) of a calibration sample (10) mounted on the sample stage, or wherein the optical imaging device is positioned to generate image data of light emitted by a surface (12) of a calibration sample (10) mounted on the sample stage, with the surface being at an angle of between 40 degrees and 50 degrees relative to an ion emitter-facing surface of the sample stage.

14. A method for an ion milling device, comprising:
obtaining (610) image data of an optical imaging device of the ion milling device, the image data showing a calibration sample mounted on a sample stage while the calibration sample is irradiated by at least one ion emitter; and
processing (620) the image data to determine at least one of a position or orientation of at least one ion beam emitted by the at least one ion emitter relative to the sample stage.

15. A computer program having a program code for performing the method according to claim 14 when the program is executed on a processor.
